# EUROPEAN PATENT APPLICATION

(11) **EP 2 006 905 A2**
(43) Date of publication of application: **24.12.2008**
(21) Application number: 08010630.5
(22) Date of filing: 11.06.2008
(51) Int. Cl.: H01L 21/84, H01L 27/12, H01L 21/762

(54) **Semiconductor apparatus and its manufacturing method**

(30) Priority: 21.06.2007 JP 2007163573
(71) Applicant: Hitachi, Ltd., Chiyoda-ku Tokyo (JP)
(72) Inventor: Kamioka, Hidekazu, Chiyoda-ku Tokyo 100-8220 (JP); Kurita, Shinichi, Chiyoda-ku Tokyo 100-8220 (JP); Takayanagi, Yuji, Chiyoda-ku Tokyo 100-8220 (JP)
(74) Representative: Beetz & Partner

(57) **Abstract**

A semiconductor apparatus (1) includes a carrier base (3), a first insulating film (4) provided on the carrier base (3), a plurality of single crystalline pillars (5a) provided on the first insulating film (4) and having the semiconductor elements (pMOS, nMOS) formed in their upper surfaces, and a second insulating film (10) formed in the form of a closed loop pattern so as to surround the side surface of the single crystalline pillar (5a). The height of the outer periphery of the upper surface of the single crystalline pillar (5a) becomes gradually smaller as it goes closer to the side surface of the single crystalline pillar (5a), and the outer periphery of the single crystalline pillar forms a tilted surface (5b) continuous to the side surface of the single crystalline pillar.

## Description

### BACKGROUND OF THE INVENTION

The present invention relates to a semiconductor apparatus which uses SOI (Silicon On Insulator), and also a method of manufacturing the semiconductor apparatus.

In order to attain higher speed operation and a higher breakdown voltage for a semiconductor apparatus, an SOI substrate is used. The SOI substrate is made up of a first insulating film and a single crystalline layer laminated on a carrier base sequentially in this order. The semiconductor apparatus using the SOI substrate includes a plurality of semiconductor elements formed on the single crystalline layer. Element isolation of the plurality of semiconductor elements is carried out by dividing the single crystalline layer by second insulating films into semiconductor elements. As a result, the semiconductor elements are isolated and separated from each other by the first and second insulating films. Thus the semiconductor apparatus using the SOI substrate has advantages that, unlike a P-N junction isolation type of semiconductor apparatus, reduction of a parasitic capacitance enables switching operation of a high-speed of the order of microseconds (*µ* seconds) or lower, a high breakdown voltage of hundreds of volts or higher, a high reliability without causing latch-up, and also one-chip formation of a logic circuit and a power switch (refer to JP-A-2007-88312, FIG. 1).

The semiconductor element is made up of the single crystalline layer divided by the second insulating films. Thus when the semiconductor element is formed to be close to the second insulating films, the surface area of each of the divided single crystalline layers can be made small and therefore the chip size of the semiconductor apparatus can be made small. When the chip size can be made small, the number of semiconductor apparatuses available from a single wafer can be increased and a yield also can be increased.

However, in the upper part of an interface between the second insulating film and the single crystalline layer, a leakage current tends to flow and the semiconductor element is formed to be spaced from the second insulating film. Therefore, it is desirable to form the semiconductor element by self alignment to be spaced by a predetermined distance from the second insulating film. It is also desirable to suppress occurrence of the leakage current in the upper part of the interface between the second insulating film and the single crystalline layer.

### SUMMARY OF THE INVENTION

It is therefore an object of the present invention to provide a semiconductor apparatus which can solve the problems in the prior art, that is, can form a semiconductor element by self alignment to be spaced by a predetermined distance from a second insulating film and can suppress generation of a leakage current in the upper part of an interface between the second insulating film and a single crystalline layer, and also to provide a method of manufacturing the semiconductor apparatus.

In accordance with an aspect of the present invention, the present invention is attained by providing a semiconductor apparatus comprising: a carrier base, a first insulating film provided on the carrier base, a plurality of single crystalline pillars provided on the first insulating film and having semiconductor elements formed on their upper surfaces, and a second insulating film formed in the form of a closed loop pattern so as to surround the side surfaces of the single crystalline pillar. In the semiconductor apparatus, the outer periphery of the upper surface of the single crystalline pillar gradually decrease in height as it is moved close to the side surface of the single crystalline pillar, and the outer periphery of the pillar eventually forms a tilted surface continuous to the side surface.

In accordance with another aspect of the present invention, the above object is attained by providing a method of manufacturing a semiconductor apparatus which includes the steps of forming a first anti-oxidation film above a single crystalline layer of an SOI substrate including a first insulating film and the single crystalline layer sequentially laminated on a carrier base, etching the single crystalline layer and the first anti-oxidation film with use of the first insulating film as a stopper in such a manner that the single crystalline layer and the first anti-oxidation film are congruent and overlapped with each other, to thereby form a plurality of single crystalline pillars on the first insulating film, thermally oxidizing part of the single crystalline pillars with the first anti-oxidation film positioned on the single crystalline pillars to thereby form a second insulating film which is formed in the form of a closed loop pattern so as to surround a side surface of the single crystalline pillar and which has an extrusion under an outer periphery of the first anti-oxidation film, exposing an upper surface of the single crystalline pillar by removing the first anti-oxidation film, and forming a semiconductor element on the upper surface of the single crystalline pillar. In the method, due to the formation of the second insulating film, the height of the upper surface of the single crystalline pillar located under the extrusion gradually decreases as it is moved close to the side surface of the single crystalline pillar, and the upper surface of the single crystalline pillar forms a tilted surface continuous to the side surface of the single crystalline pillar.

In the present invention, there can be provided a semiconductor apparatus which can form a semiconductor element by self alignment to be spaced by a predetermined distance from the second insulating film and can suppress generation of a leakage current in the upper part of an interface between the second insulating film and the single crystalline layer, and also to provide a method of manufacturing the semiconductor apparatus.

### BRIEF DESCRIPTION OF THE DRAWINGS

FIG. 1(a) is a top plan view (when layers including a passivation film are partly removed) of a semiconductor apparatus in accordance with a first embodiment of the present invention;
FIG. 1(b) is a cross-sectional view of the semiconductor apparatus taken along line I-I in FIG. 1(a);
FIG. 2 is a cross-sectional view in a manufacturing step for explaining a method of manufacturing the semiconductor apparatus in accordance with the first embodiment of the invention;
FIG. 3(a) is a first top plan view in the manufacturing step for explaining the method of manufacturing the semiconductor apparatus in accordance with the first embodiment of the invention;
FIG. 3(b) is a cross-sectional view taken along line III-III in FIG. 3(a);
FIG. 4(a) is a second top plan view in the manufacturing step for explaining the method of manufacturing the semiconductor apparatus in accordance with the first embodiment of the invention;
FIG. 4(b) is a cross-sectional view taken along line IV-IV in FIG. 4(a);
FIG. 5(a) is a third top plan view in the manufacturing step for explaining the method of manufacturing the semiconductor apparatus in accordance with the first embodiment of the invention;
FIG. 5(b) is a cross-sectional view taken along line V-V in FIG. 5(a);
FIG. 6(a) is a top plan view (when layers including a passivation film are partly removed) of a semiconductor apparatus in accordance with a second embodiment of the present invention;
FIG. 6(b) is a cross-sectional view taken along line VI-VI in FIG. 6(a);
FIG. 7(a) is a first top plan view in a manufacturing step for explaining a method of manufacturing the semiconductor apparatus in accordance with the second embodiment of the invention;
FIG. 7(b) is a cross-sectional view taken along line VII-VII in FIG. 7(a);
FIG. 8(a) is a second top plan view in the manufacturing step for explaining the method of manufacturing the semiconductor apparatus in accordance with the second embodiment of the invention;
FIG. 8(b) is a cross-sectional view taken along line VIII-VIII in FIG. 8(a);
FIG. 9(a) is a third top plan view in the manufacturing step for explaining the method of manufacturing the semiconductor apparatus in accordance with the second embodiment of the invention; and
FIG. 9(b) is a cross-sectional view taken along line IX-IX in FIG. 9(a).

### DESCRIPTION OF THE EMBODIMENTS

Embodiments of the present invention will be detailed with reference to the attached drawings. In these drawings, components having common functions are denoted by the same reference numerals or symbols and overlapped explanation thereof is omitted.

### (Embodiment 1)

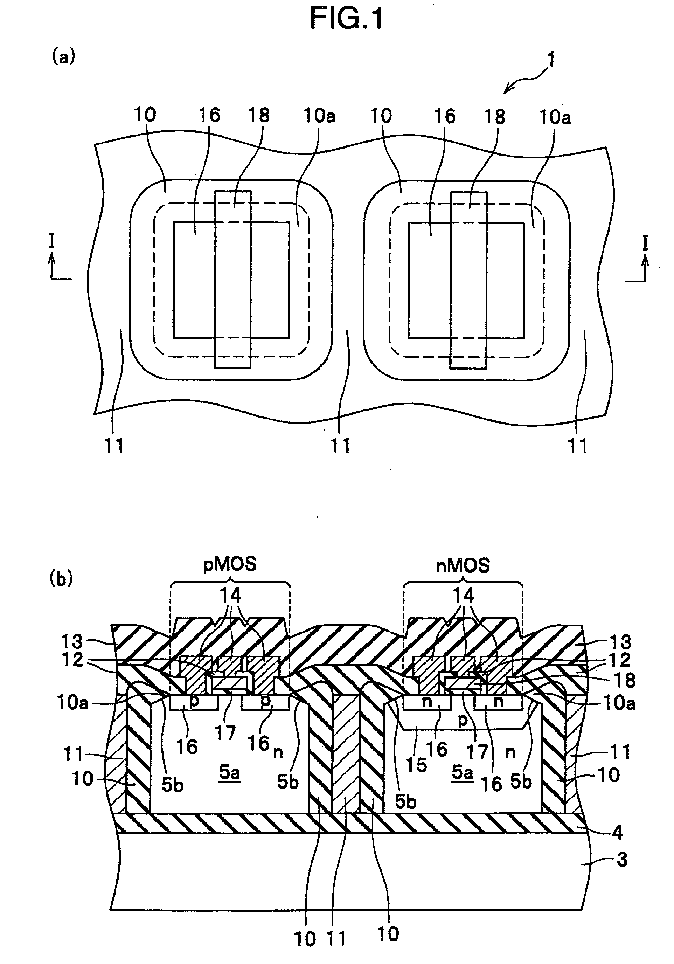

FIG. 1(a) shows a top plan view of a semiconductor apparatus 1 in accordance with a first embodiment of the present invention when upper layers located above a gate 18 (that is, a passivation film 13, an interlayer insulating film 12, and electrodes 14 in FIG. 1(b)) are partly removed and seen from the top. FIG. 1(b) is a cross-sectional view taken along line I-I in FIG. 1(a).

The semiconductor apparatus 1 uses an SOI substrate. The SOI substrate has a carrier base 3, a first insulating film 4 provided on the carrier base 3, and a plurality of single crystalline pillars 5a provided on the first insulating film 4, as shown in FIG. 1(b). The plurality of single crystalline pillars 5a have an identical height, are positioned close to each other, and form a so-called single crystalline layer.

Semiconductor elements pMOS and nMOS are formed on the respective upper surfaces of the single crystalline pillars 5a respectively. Although explanation will be made in connection with an example where the semiconductor elements include p type of MOSFET (pMOS) and n type of MOSFET (nMOS) in the first embodiment, the semiconductor elements may include a power semiconductor switching element such as an IGBT or bipolar transistor. In this connection, MOS stands for Metal Oxide Semiconductor, FET stands for Field Effect Transistor, and IGBT stands for Insulated Gate Bipolar Transistor.

The p type MOSFET (pMOS) has the gate 18 provided to be extended longitudinally of the single crystalline pillar 5a as shown by the left side of FIG. 1(a), a gate insulating film 17 provided so as to be laminated on the lower side of the gate 18 as shown by the left side of FIG. 1(b), and a source/drain region 16 of a p conduction type formed in the upper part of the single crystalline pillar 5a of an n conduction type and separated by the gate 18 and the gate insulating film 17 into right and left regions. The interlayer insulating film 12 is formed on the gate 18 and the source/drain region 16. The electrodes 14 are passed through the interlayer insulating film 12 and led out to be connected to the gate 18 and the source/drain region 16 respectively. The passivation film 13 is formed on the interlayer insulating film 12 and the electrodes 14.

Similarly, the n type of MOSFET (nMOS) has a gate 18 provided so as to be extended longitudinally of a single crystalline pillar 5a as shown in the right side of FIG. 1(a), a gate insulating film 17 so as to be laminated on the lower side of the gate 18 as shown by the right side of FIG. 1(b), and a source/drain region 16 of an n conduction type formed on the single crystalline pillar 5a of the n conduction type and separated by the gate 18 and the gate insulating film 17 into right and left regions. The source/drain region 16 of the n conduction type is formed in the upper part of a well 15 of a p conduction type formed in the upper part of the single crystalline pillar 5a of the n conduction type. The structures of the interlayer insulating film 12, the electrodes 14, and the passivation film 13 are the same as those of the p type MOSFET (pMOS).

With respect to the outer periphery of the upper surface of the single crystalline pillar 5a, as it is moved toward the side surface of the single crystalline pillar 5a, the height of the upper surface of the single crystalline pillar gradually decreases, and the outer periphery of the pillar eventually forms a tilted surface 5b continuous to the side surface of the single crystalline pillar 5a. A p type MOSFET (pMOS) and an n type MOSFET (nMOS) are formed inside the tilted surface 5b and in the upper surface of the single crystalline pillar 5a.

In accordance with the first embodiment, the height of the outer periphery of the upper surface of the single crystalline pillar 5a gradually decreases as it is moved close to the side surface of the single crystalline pillar 5a. Thus the upper part of an interface between a second insulating film 10 and the side surface of the single crystalline pillar 5a, where a leakage current tends to flow, can be removed. As a result, the leakage current flowing in the single crystalline pillar 5a can be suppressed. Since the generation source of the leakage current is removed, the semiconductor element can be formed closer to the second insulating film 10 (that is, be formed to be spaced by a distance corresponding to the width (when viewed from the top) of the tilted surface 5b. Since the semiconductor element can be formed closer to the second insulating film 10, the chip size of the semiconductor apparatus 1 can be made small. Since the chip size can be made small, the number of chips available from a single sheet of wafer can be increased and therefore a yield can also be increased.

The second insulating film 10 is formed so as to come into contact with the respective side surfaces of the single crystalline pillars 5a. The second insulating film 10 is formed so as to surround the side surface of the single crystalline pillar 5a, thus forming a closed loop pattern.

The upper end of the second insulating film 10 forms a bird's beak (extrusion) 10a which is extruded to have a wedge (bird's beak) shape in sectional view and which is provided on the tilted surface 5b, as shown in FIG. 1(b). Thus, the height of the lower surface of the bird's beak 10a contacted with the tilted surface 5b becomes gradually smaller as it is moved toward the side surface of the single crystalline pillar 5a.

The upper surface of the bird's beak 10a located above the tilted surface 5b becomes gradually higher from the inside of the single crystalline pillar 5a toward its outer periphery. That is, the thickness of the bird's beak 10a from the tip end of the bird's beak toward its base end is gradually larger. The second insulating film 10 including the bird's beak 10a is formed as a thermal oxidation film manufactured by thermally oxidizing part of the single crystalline pillar 5a.

In the first embodiment, the p type MOSFET (pMOS) and the n type MOSFET (nMOS) are formed to be separated by a distance corresponding to the width of the bird's beak 10a from the second insulating film 10. Since the bird's beak 10a can be formed together with the second insulating film 10 by a LOCOS (local oxidation of silicon: selective oxidation) process (which will be explained later), the width of the bird's beak 10a with respect to the thickness of the second insulating film 10 can be determined by self alignment. Since the thickness of the second insulating film 10 can be adjusted according to the oxidation time of the LOCOS method, the width of the bird's beak 10a can also be modified according to the thickness of the second insulating film 10.

A polycrystalline polysilicon film 11 is buried in a gap between the second insulating films 10 formed on the side surfaces of the single crystalline pillars 5a. The interlayer insulating film 12 and the passivation film 13 are laminated on the polycrystalline polysilicon film 11 and the second insulating film 10.

Explanation will next be made as to a method of manufacturing the semiconductor apparatus 1 in accordance with the first embodiment of the present invention.

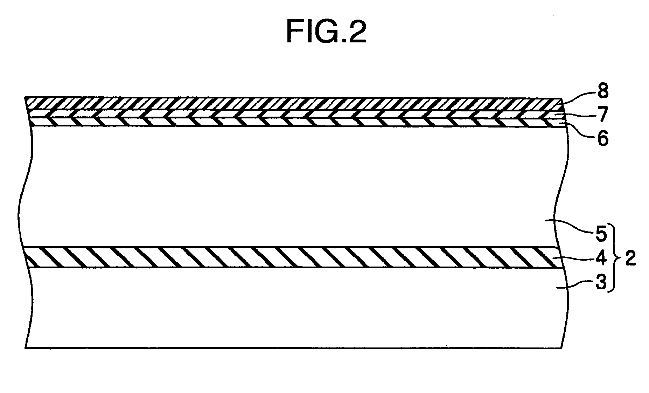

An SOI substrate 2 having the first insulating film 4 and a single crystalline layer 5 sequentially laminated on such a carrier base 3 as shown in FIG. 2 is prepared. A silicon oxide (SiO₂) film may used as the first insulating film 4, and an n type of single crystalline silicon (Si) layer may be used as the single crystalline layer 5. In this connection, the conduction type of the single crystalline layer 5 is not limited to an n type but a p type may be employed therefor. When the p type is employed, the n or p conduction type of the source/drain region 16 or the like are inverted respectively.

A silicon oxide film as an insulating film 6 is formed in the upper part of the single crystalline layer 5 by thermally oxidizing the upper part of the single crystalline layer 5. A silicon nitride (Si₃N₄) film as a first anti-oxidation film 7 is formed by a low pressure CVD (chemical vapor deposition) method on the insulating film 6, that is, above the single crystalline layer 5. A resist layer 8 is formed on the first anti-oxidation film 7.

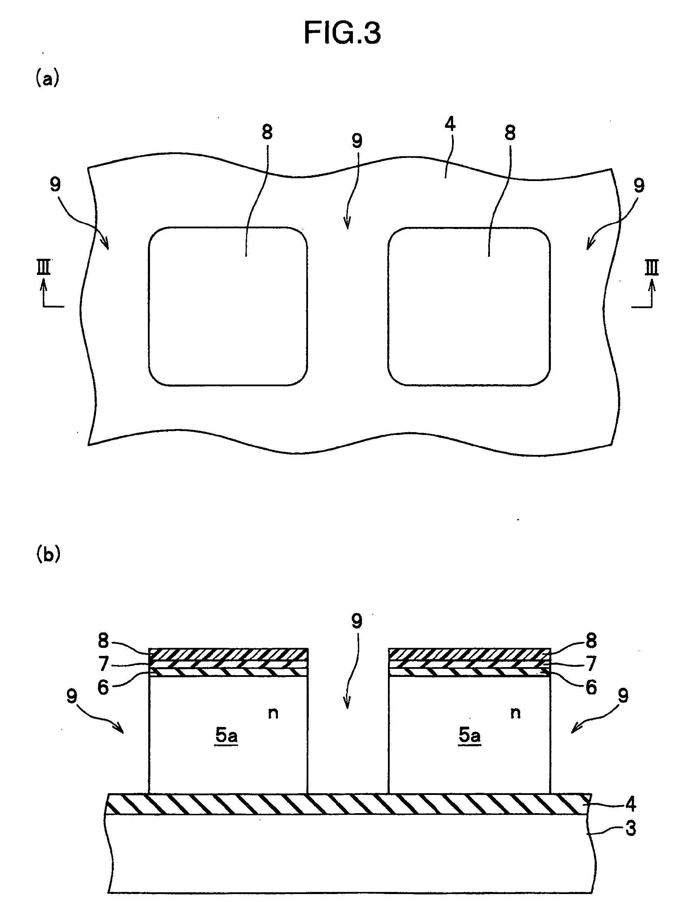

As shown in FIGS. 3(a) and 3(b), the resist layer 8 is patterned by photolithography.

Next, the first anti-oxidation film 7, the insulating film 6, and the single crystalline layer 5 (see FIG. 2) are sequentially etched by anisotropic dry etching with use of the resist layer 8 as a mask and the first insulating film 4 as a stopper. A plurality of single crystalline pillars 5a are formed on the first insulating film 4. A trench 9 is formed between the plurality of single crystalline pillars 5a. Since the resist layer 8 is used as a common mask during each etching of the first anti-oxidation film 7, the insulating film 6, and the single crystalline layer 5 (see FIG. 2); the single crystalline pillar 5a, the insulating film 6, and the first anti-oxidation film 7 are congruent and overlapped with each other when viewed from the top. The resist layer 8 is removed by ashing and by a sulfuric acid (H₂SO₄) wet process. In the first embodiment, etching has been carried out as far as the single crystalline layer 5 with use of the resist layer 8 as the mask. However, the present invention is not limited to this specific example, but only the first anti-oxidation film 7 may be etched or only the first anti-oxidation film 7 and the insulating film 6 may be etched, with use of the resist layer 8 as the mask. In the latter case, the resist layer 8 is removed prior to the etching of the single crystalline layer 5, and the single crystalline layer 5 is etched by anisotropic dry etching with use of the first anti-oxidation film 7 as a mask and the first insulating film 4 as a stopper. The single crystalline pillar 5a, the insulating film 6, and the first anti-oxidation film 7 may be made congruent and be overlapped with each other when viewed from the top.

For the anisotropic dry etching of the single crystalline layer 5 with use of the first insulating film 4 as the stopper, a dry etching apparatus and an ICP (Inductively Coupled Plasma) dry etching apparatus are used. Gases of chlorine (Cl₂), sulfur hexafluoride (SF₆), hydrogen bromide (HBr) , oxygen (O₂) and so on are used as the etching gas. When the chlorine gas and the oxygen gas are used for example; an etching selectivity between the silicon (Si) of the single crystalline layer 5 and the silicon oxide (SiO₂) of the first insulating film 4 in a microwave dry etching apparatus can be made to be about 15 to 30, the first insulating film 4 at the bonding interface can play a role of etch stopper, and the plurality of single crystalline pillars 5a having the same height can be obtained.

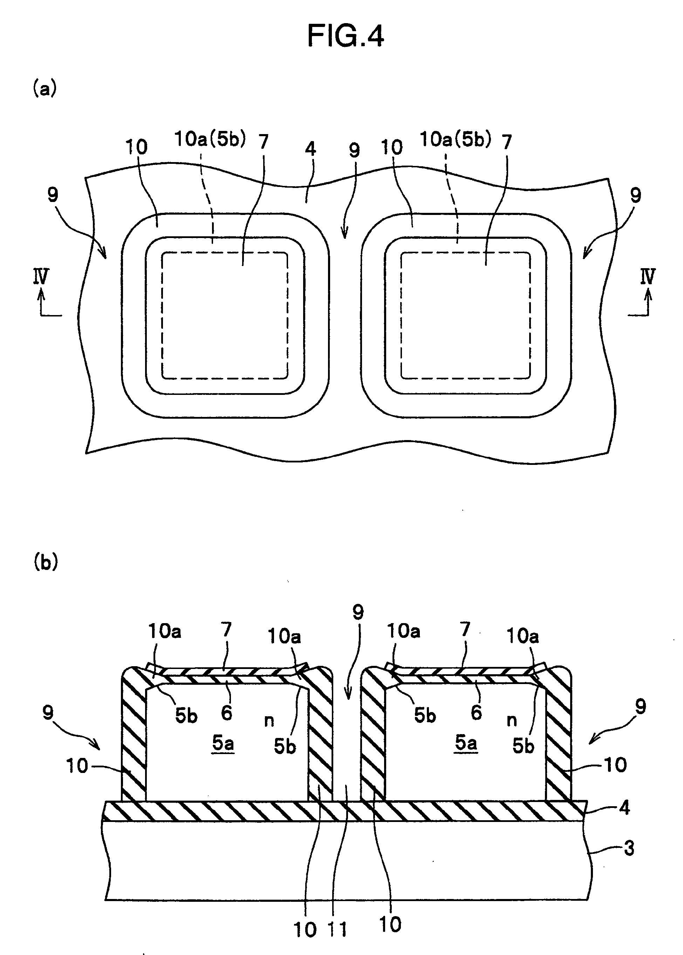

As shown in FIGS. 4(a) and 4(b), parts of the single crystalline pillars 5a are then thermally oxidized, with the first anti-oxidation film 7 positioned above the single crystalline pillars 5a. a second insulating film 10 as closed loop pattern is formed so as to surround the side surface of each of the single crystalline pillars 5a. The second insulating film 10 is made of a silicon oxide film. Upon the formation of the second insulating film 10, a bird's beak 10a of a wedge shape when viewed from the cross-section is formed under the outer periphery of the first anti-oxidation film 7. This is because the upper surface (insulating film 6) of the single crystalline pillar 5a is protected by the first anti-oxidation film 7, so that the upper surface of the single crystalline pillar 5a is not oxidized and only the side surface of the single crystalline pillar 5a is oxidized by oxygen diffusion from its side surface. In particular, since the upper part of the single crystalline pillar 5a in the vicinity of the first anti-oxidation film 7 experiences a strong stress from the first anti-oxidation film 7 or the insulating film 6, thermal oxidation tends to advance from the end of the outer periphery of the first anti-oxidation film 7, with the result that the bird's beak 10a having a typical structure of selective oxidation (LOCOS). That is, as a result of the thermal oxidation of the single crystalline pillar 5a, the volume of the second insulating film 10 formed by the oxidation is about twice the volume of the single crystalline pillar 5a lost by the oxidation. With respect to the bird's beak 10a, the volume of the outer periphery of the upper part of the single crystalline pillar 5a is decreased by the oxidation, and the height of the lower surface of the bird's beak 10a contacted with the tilted surface 5b becomes gradually lower as it goes closer to the side surface of the single crystalline pillar 5a. The volume of the second insulating film 10 generated by the oxidation becomes twice the volume of the single crystalline pillar 5a decreased by the oxidation. As a result, the upper surface of the tilted surface 5b of the bird's beak 10a is not horizontal but becomes gradually higher in height from the tip end of the bird's beak 10a toward the base end thereof. In other words, the thickness of the bird's beak 10a above the tilted surface 5b becomes gradually larger as it goes from the inner side of the single crystalline pillar 5a toward its outer periphery, while kept at twice the thickness of the single crystalline pillar 5a decreased by the oxidation.

The upper part of an interface between the second insulating film 10 and the side surface of the single crystalline pillar 5a, that is, the shoulder of the single crystalline pillar 5a tends to be susceptible to a crystal defect due to concentration of a stress caused by the insulating film contacted with the side surface of the single crystalline pillar 5a and also due to a stress caused by the insulating film contacted with the upper surface thereof. For this reason, a leakage current tends to flow and a breakdown voltage tends to be decreased in the semiconductor apparatus. Since the shoulder forms the bird's beak 10a, the corner of the shoulder can be rounded to have a round shape and thus the stress acting on the single crystalline pillar 5a can be reduced. This can also be considered as a case of shifting the stress concentrated location to the interior of the second insulating film 10. For this reason, occurrence of a crystal defect within the single crystalline pillar 5a can be suppressed, a leakage current can be reduced, and a breakdown voltage can be increased.

When the second insulating film 10 is formed on the side surface of the single crystalline pillar 5a, the width of the trench 9 becomes smaller because the aforementioned volume becomes twice. The thickness of the second insulating film 10 is set so that the adjacent opposing second insulating films 10 are not contacted with each other.

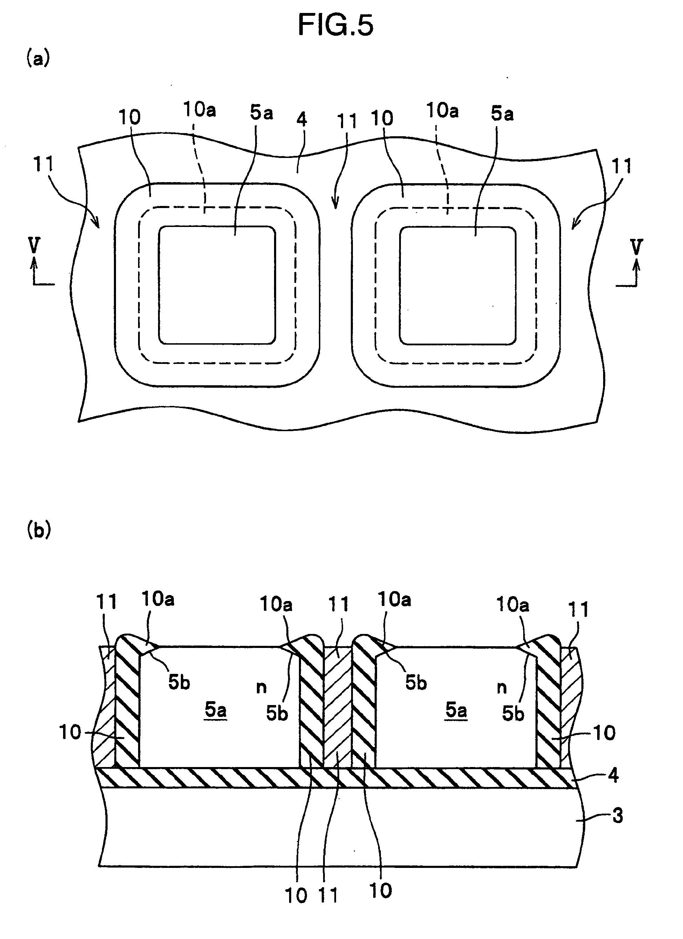

As shown in FIGS. 5(a) and 5(b), next, a polycrystalline polysilicon film 11 is formed by a chemical vapor deposition (CVD) method at a low temperature (of 500°C to 800°C) to bury the trench 9 (refer to FIGS. 4(a) and 4(b)). The first anti-oxidation film 7 (refer to FIGS. 4(a) and 4(b)) and the polycrystalline polysilicon film 11 deposited on the second insulating film 10 are removed by chemical mechanical polishing (CMP) or by dry etching. As shown in FIGS. 5(a) and 5(b), after the removal, the polycrystalline polysilicon film 11 buried in the trench 9 (refer to FIGS. 4(a) and 4(b)), that is, only the so-called buried polycrystalline polysilicon film can be left.

As shown in FIGS. 5(a) and 5(b) , the first anti-oxidation film 7 (refer to FIGS. 4(a) and 4(b)) as a silicon nitride film is then removed with hot phosphoric acid (HsPO₄) at a temperature of 150°C to 200°C). The insulating film 6 as the silicon oxide film is removed by etching with use of a hydrofluoric acid (HF) solution as an etchant. Through the above processes, the upper surface of the single crystalline pillar 5a can be exposed. The exposed upper surface of the single crystalline pillar 5a becomes an active region in which a semiconductor element can be formed.

According to the first embodiment, a semiconductor element is formed to be spaced from the interface between the second insulating film 10 and the side surface of the single crystalline pillar 5a by an amount corresponding to the width of the bird's beak 10a (tilted surface 5b). Since the bird's beak 10a can be formed together with the second insulating film 10 by the LOCOS (selective oxidation) method, the width of the bird's beak 10a can be determined by self alignment with respect to the thickness of the second insulating film 10. Since the thickness of the second insulating film 10 can be adjusted according to the oxidation time or the like of the LOCOS method, the width of the bird's beak 10a can also be modified according to the thickness of the second insulating film 10. In the first embodiment, in this way, the semiconductor element can be formed by self alignment to be spaced by a predetermined distance from the second insulating film 10. In the upper part of the interface between the second insulating film 10 and the side surface of the single crystalline pillar 5a, a crystal defect tends to occur, a leakage current tends to flow, and a breakdown voltage tends to be reduced. However, since the semiconductor element can be formed to be spaced by a predetermined distance from the second insulating film 10, the reduction of the leakage current and the increase of the breakdown voltage can be easily attained. Since the predetermined distance can be determined by self alignment, manufacturing variations can be made small and as its result, the predetermined distance can be set at a small value. For this reason, the semiconductor element can be formed closer to the second insulating film 10 and the surface area of the upper surface of each single crystalline pillar 5a can be made smaller. This results in that the chip size of the semiconductor apparatus can be made smaller. The smaller chip size enables increase of the number of semiconductor apparatuses available from a single sheet of wafer and also enables increase of a yield.

As shown in FIGS. 1(a) and 1(b), finally, a p type MOSFET (pMOS) and an n type MOSFET (nMOS) are formed as semiconductor elements respectively in the active regions of the upper surface of the single crystalline pillar 5a surrounded by the bird's beaks 10a (tilted surface 5b). As a method of manufacturing the p type MOSET (pMOS) and the n type MOSFET (nMOS), a prior art manufacturing method may be employed.

As shown in FIG. 1(b), the interlayer insulating film 12 and the passivation film 13 are located so as to be extended beyond the bird's beak 10a and to cover it. Since the tilt of the upper surface of the bird's beak 10a is gentle, however, a failure caused by no coverage of the bird's beak 10a can be avoided. The tilt of the upper surface of the bird's beak 10a is gentle. This is because the position of the lower surface of the bird's beak 10a is also set at a deep level even when the thickness of the bird's beak 10a becomes large.

More specifically, when the second insulating film 10 has a thickness of 1 µm, the bird's beak 10a has also a largest thickness of 1 µm. However, the height of the highest part of the bird's beak 10a is higher by 0.55 µm than the upper surface of the single crystalline pillar 5a, and the height of the lowest part of the bird's beak 10a is lower by 0.45µm than the upper surface of the single crystalline pillar 5a. This means that the interlayer insulating film 12 and the passivation film 13 are only required to be extended beyond a step having a height of 0.55µm in order to go beyond the bird's beak 10a having the thickness of 1µm, and in other words, the step can be considered to be substantially lowered.

### (Embodiment 2)

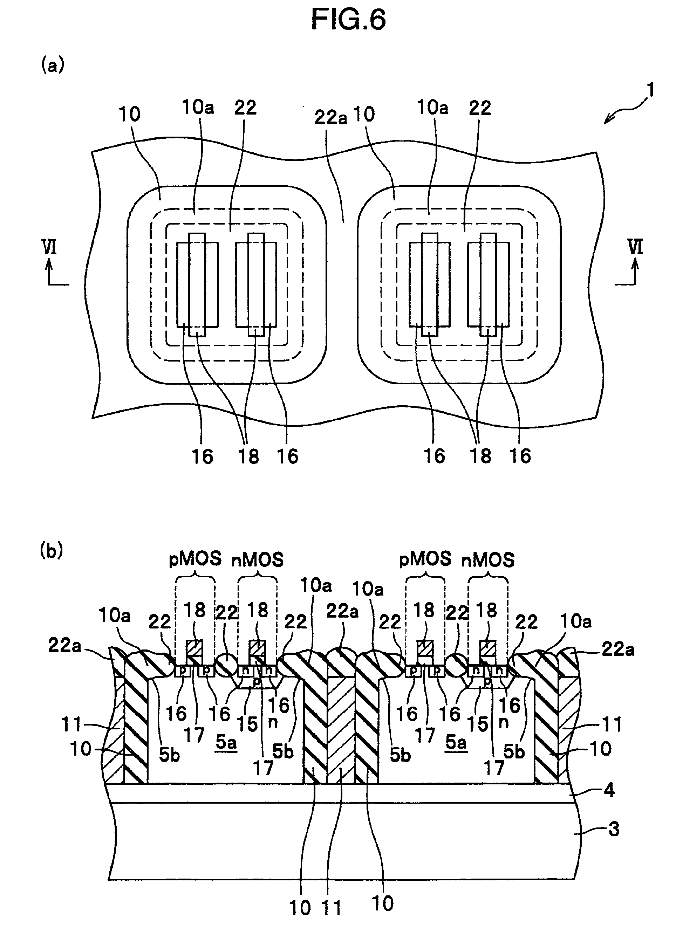

FIG. 6(a) is a top plan view of a semiconductor apparatus 1 in accordance with a second embodiment of the present invention, and FIG. 6(b) is a cross-sectional view taken along line VI-VI in FIG. 6(a). In FIG. 6(a), the passivation film 13, the interlayer insulating film 12, and the electrodes 14 shown in FIG. 1(b) are omitted and not illustrated.

As shown in FIGS. 6(a) and 6(b), the semiconductor apparatus 1 in accordance with the second embodiment of the invention is different from the semiconductor apparatus 1 of the first embodiment in that pluralities of semiconductor elements pMOS and nMOS are formed for each of the single crystalline pillars 5a. For the purpose of attaining element isolation between these semiconductor elements pMOS and nMOS, a third insulating film 22 is provided. To this end, the third insulating films 22 are provided on the upper surface of the single crystalline pillar 5a between the semiconductor elements pMOS and nMOS. The third insulating film 22 is provided on the upper surface of the single crystalline pillar 5a between the tilted surface 5b (bird's beak (extrusion) 10a) and the semiconductor elements pMOS and nMOS.

The third insulating film 22 is made of a thermally oxidized film obtained by thermally oxidizing part of the single crystalline pillar 5a. In the vicinity of the semiconductor elements pMOS and nMOS, the thickness of the third insulating film 22 becomes gradually smaller as it goes closer to the semiconductor elements pMOS and nMOS. A part of the third insulating film 22 having a thickness gradually smaller as it goes closer to the side surface of the semiconductor elements pMOS and nMOS, forms a bird's beak.

The thickness of the bird's beak 10a of the second insulating film 10 is increased by the thermal oxidation of formation of the third insulating film 22, and the bird's beak 10a has a thickness not smaller than the thickness of the third insulating film 22 at an end of the tilted surface 5b.

The height of the outer periphery of the upper surface of the single crystalline pillar 5a becomes gradually lower as it goes closer to the side surface of the single crystalline pillar 5a, and the outer periphery forms the tilted surface 5b continuous to the side surface of the single crystalline pillar 5a. Inside the tilted surface 5b, a p type MOSFET (pMOS) and an n type MOSFET (nMOS) are formed with the third insulating film 22 disposed therebetween.

The height of the lower surface of the bird's beak 10a contacted with the tilted surface 5b becomes gradually lower as it goes closer to the side surface of the single crystalline pillar 5a. The upper surface of the bird's beak 10a becomes gradually higher as it goes from its tip end to its base end. The bird's beak 10a has thicknesses gradually increased from its tip end to its base end.

In the second embodiment, the p type MOSFET (pMOS) and the n type MOSFET (nMOS) can be formed to be spaced from the second insulating film 10 at least by an amount corresponding to the width of the bird's beak 10a. With such a structure, similarly to the first embodiment, a leakage current can be reduced. In the second embodiment, the outer periphery of the upper surface of the single crystalline pillar 5a becomes gradually lower in height as it goes closer to the side surface of the single crystalline pillar 5a. The upper part of the single crystalline pillar 5a at an interface between the second insulating film 10 and the side surface of the single crystalline pillar 5a where a leakage current tends to flow, can be omitted, and thus similarly to the first embodiment, the leakage current can be lowered.

A third insulating film 22a is formed simultaneously by the thermal oxidation of formation of the third insulating film 22.

Explanation will then be made as to a method of manufacturing a semiconductor apparatus 1 in accordance with the second embodiment of the present invention. The method of manufacturing the semiconductor apparatus 1 in the second embodiment is the same as the method of manufacturing the semiconductor apparatus in the first embodiment, until the structure shown in FIGS. 5(a) and 5(b) in the method of manufacturing the semiconductor apparatus in the first embodiment is completed.

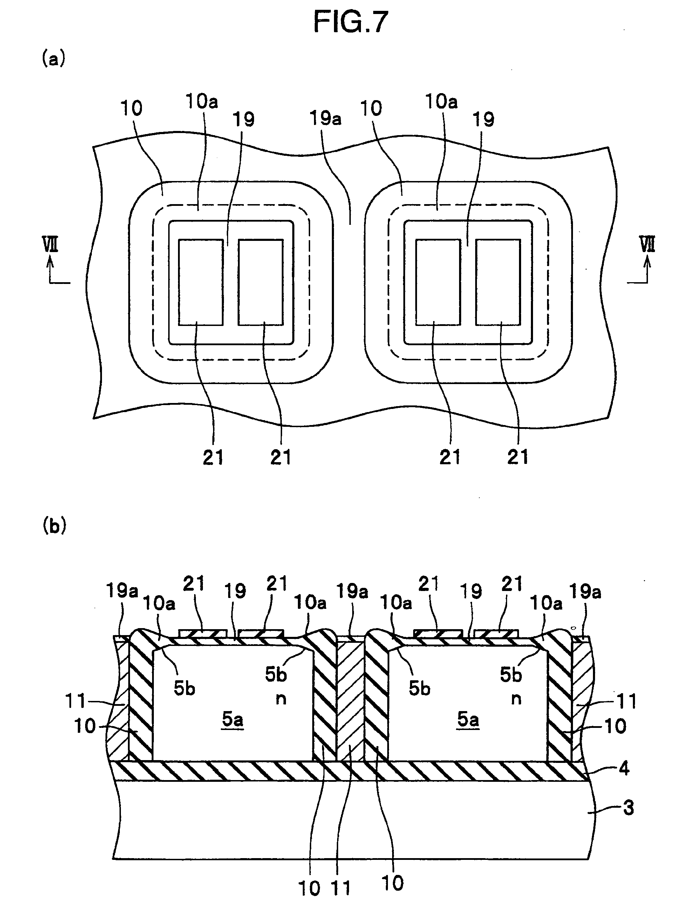

As shown in FIGS. 7(a) and 7(b), next, an exposed part of the upper surface of the single crystalline pillar 5a is thermally oxidized to form an insulating film 19 on the upper surface of the single crystalline pillar 5a. Upon the thermal oxidation, an exposed surface of the polycrystalline polysilicon film 11 is also thermally oxidized to form an insulating film 19a on the polycrystalline polysilicon film 11.

A silicon nitride film as second anti-oxidation films 21 is then formed by a low pressure CVD method on the insulating film 19, that is, above the single crystalline pillar 5a. The second anti-oxidation film 21 is patterned by photolithography to form a plurality of divided second anti-oxidation films 21 corresponding to a plurality of semiconductor elements including, for example, the p type MOSFET (pMOS) and the n type MOSFET (nMOS) on an area where the plurality of semiconductor elements are to be formed.

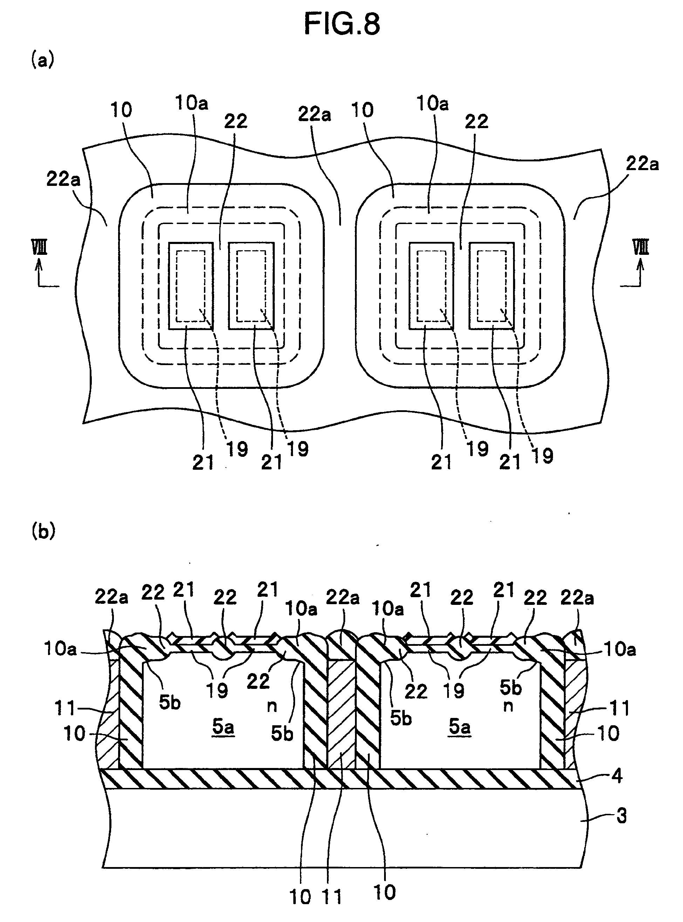

As shown in FIGS. 8(a) and 8(b), next, the second anti-oxidation films 21 are thermally oxidized with the second anti-oxidation films 21 positioned above the single crystalline pillar 5a. A third insulating film 22 as an element isolation region is formed around each of the second anti-oxidation films 21. Under the outer periphery of the second anti-oxidation film 21, a bird's beak of the third insulating film 22 is formed. The third insulating film 22 is formed not only between the adjacent second anti-oxidation films 21 but also between the second anti-oxidation film 21 and the bird's beak 10a.

Even when the patterning of the second anti-oxidation film 21 is offset and the second anti-oxidation film 21 is overlapped with the bird's beak 10a, the semiconductor elements are formed avoiding the bird's beaks 10a. Thus the semiconductor elements can be formed to be spaced from each other at least by an amount corresponding to the width of the bird's beak 10a from the position of the side surface of the single crystalline pillar 5a.

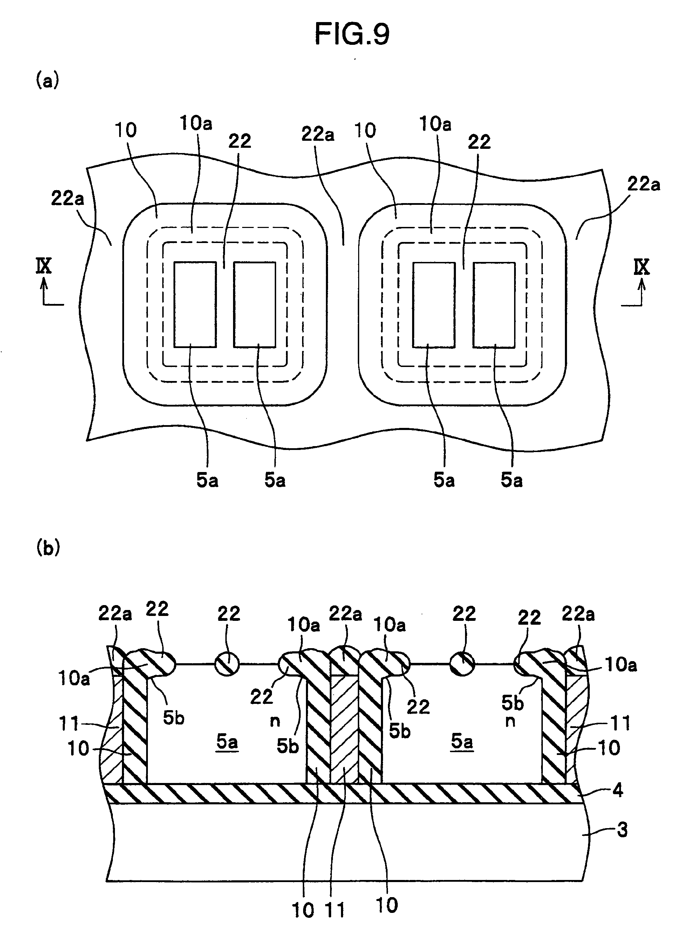

As shown in FIGS. 9(a) and 9(b), the second anti-oxidation films 21 (refer to FIGS. 8(a) and 8(b)) as silicon nitride films are then removed with hot phosphoric acid at a temperature of 150°C to 200°C. The insulating films 19 (refer to FIGS. 8(a) and 8(b)) as silicon oxide films are removed by etching with use of a hydrofluoric acid solution or the like as an etchant. Through the above processes, the upper surface of the single crystalline pillar 5a can be exposed. The exposed upper surface of the single crystalline pillar 5a becomes an active area where the semiconductor elements are to be formed.

As shown in FIGS. 6(a) and 6(b), finally, a p type MOSFET (pMOS) and an n type MOSFET (nMOS) are formed as semiconductor elements in an active area of the upper surface of the single crystalline pillar 5a surrounded by the third insulating film 22. As a method of manufacturing the p type MOSFET (pMOS) and the n type MOSFEF (nMOS), a prior art manufacturing method may be employed.

## Claims

1. A semiconductor apparatus (1) comprising:
a carrier base (3);
a first insulating film (4) provided on the carrier base;
a plurality of single crystalline pillars (5a) provided on the first insulating film and having semiconductor elements (pMOS, nMOS) formed on their upper surfaces; and
a second insulating film (10) formed in the form of a closed loop pattern so as to surround the side surfaces of the single crystalline pillar (5a),
**characterized in that** the height of the upper surface of the single crystalline pillar (5a) becomes gradually lower as it goes closer to the side surface of the single crystalline pillar (5a) in the outer periphery of the upper surface of the single crystalline pillar, and the outer periphery eventually forms a tilted surface (5b) continuous to the side surface.

2. The semiconductor apparatus (1) according to claim 1, **characterized in that** the second insulating film (10) has an extrusion (10a) extruded onto the tilted surface (5b).

3. The semiconductor apparatus (1) according to claim 2, **characterized in that** a height of an upper surface of the extrusion (10a) of the second insulating film (10) becomes gradually larger as it goes from a tip end of the extrusion (10a) to a base end thereof.

4. The semiconductor apparatus (1) according to claim 2 or 3, **characterized in that** a thickness of the extrusion (10a) of the second insulating film (10) becomes gradually larger it goes from a tip end of the extrusion to a base end thereof.

5. The semiconductor apparatus (1) according to any one of claims 1 to 4, **characterized in that** the second insulating film (10) is a thermal oxidation film obtained by thermally oxidizing the single crystalline pillar (5a).

6. The semiconductor apparatus (1) according to any one of claims 1 to 5, **characterized in that** the semiconductor element (pMOS, nMOS) is formed on the upper surface of the single crystalline pillar (5a) inside the tilted surface (5b).

7. The semiconductor apparatus (1) according to any one of claims 1 to 6, **characterized in that** a third insulating film (22) for providing mutual isolation between the semiconductor elements (pMOS, nMOS) is provided on the upper surface of the single crystalline pillar (5a) between the tilted surface (5b) and the semiconductor element (pMOS, nMOS) and between the semiconductor elements (pMOS, nMOS).

8. The semiconductor apparatus (1) according to claim 7, **characterized in that** the third insulating film (22) is a thermal oxidation film obtained by thermally oxidizing the single crystalline pillar (5a), and a thickness of the third insulating film (22) becomes gradually larger as it goes closer to the semiconductor elements (pMOS, nMOS) in the vicinity of the semiconductor elements (pMOS, nMOS).

9. The semiconductor apparatus (1) according to claim 7 or 8, **characterized in that** a thickness of the second insulating film (10) above the tilted surface (5b) is not smaller than the thickness of the third insulating film (22) at an end of the tilted surface (5b).

10. A method of manufacturing a semiconductor apparatus (1) comprising the steps of:
forming a first anti-oxidation film (7) above a single crystalline layer of an SOI substrate including a first insulating film (4) and the single crystalline layer sequentially laminated on a carrier base (3);
etching the single crystalline layer and the first anti-oxidation film (7) with use of the first insulating film (4) as a stopper in such a manner that the single crystalline layer and the first anti-oxidation film (7) are congruent and overlapped with each other, to thereby form a plurality of single crystalline pillars (5a) on the first insulating film (4) ;
thermally oxidizing part of the single crystalline pillars (5a) with the first anti-oxidation film (7) positioned on the single crystalline pillars (5a) to thereby form a second insulating film (10) which is formed in the form of a closed loop pattern so as to surround a side surface of the single crystalline pillar and which has an extrusion (10a) under an outer periphery of the first anti-oxidation film (7);
exposing an upper surface of the single crystalline pillar (5a) by removing the first anti-oxidation film (7); and
forming a semiconductor element (pMOS, nMOS) on the upper surface of the single crystalline pillar, and
**characterized in that** formation of the second insulating film (10) enables a height of the upper surface of the single crystalline pillar (5a) under the extrusion (10a) to become gradually smaller as it goes closer to the side surface of the single crystalline pillar, and the upper surface of the single crystalline pillar forms a tilted surface (5b) continuous to the side surface of the single crystalline pillar.

11. The method of manufacturing the semiconductor apparatus (1) according to claim 10, **characterized in that** a second anti-oxidation film (21) is formed in a region where a semiconductor element (pMOS, nMOS) is to be formed on the exposed upper surface of the single crystalline pillar (5a), and the upper surface of the single crystalline pillar is thermally oxidized between a tilted surface (5b) of the single crystalline pillar and the semiconductor element (pMOS, nMOS) and between the semiconductor elements (pMOS, nMOS) with the second anti-oxidation film (21) positioned on the single crystalline pillar (5a) to thereby form a third insulating film (22) which has a bird's beak (10a) around the element formation region and which provides mutual isolation between the semiconductor elements (pMOS, nMOS).
